# EUROPEAN PATENT SPECIFICATION

(11) **EP 3 518 630 B1**
(45) Date of publication and mention of the grant of the patent: **09.07.2025**
(21) Application number: 18153952.9
(22) Date of filing: 29.01.2018
(51) Int. Cl.: H05K 3/06

(54) **ANISOTROPIC ETCHING USING DIFFERENT ETCHING COMPOSITIONS**
ANISOTROPES ÄTZEN MIT UNTERSCHIEDLICHEN ÄTZZUSAMMENSETZUNGEN
GRAVURE ANISOTROPE UTILISANT DIFFÉRENTES COMPOSITIONS DE GRAVURE

(43) Date of publication of application: 31.07.2019
(73) Proprietor: AT & S Austria Technologie & Systemtechnik Aktiengesellschaft, 8700 Leoben-Hinterberg (AT)
(72) Inventor: Klocek, Jolanta, 8700 Leoben (AT); Krivec, Thomas, 8740 Zeltweg (AT)
(74) Representative: Donatello, Daniele

(56) References cited:
- EP-A1- 3 184 669
- US-A- 5 858 257
- US-A1- 2006 199 394
- US-A1- 2010 252 530
- US-A1- 2011 049 104
- US-A1- 2011 056 910
- US-A1- 2015 267 305

## Description

The invention relates to a method of etching an electrically conductive layer structure (hereinafter, also simply referred to as an "etching process"), and an apparatus for etching an electrically conductive layer structure (hereinafter, also simply referred to as an "etching apparatus").

In the context of growing product functionalities of component carriers equipped with one or more components and increasing miniaturization of such components as well as a rising number of components to be mounted on component carriers such as printed circuit boards (PCBs), increasingly more powerful array-like components or packages having several components are being employed, which have a plurality of contacts or connections, with ever smaller spacing between these contacts.

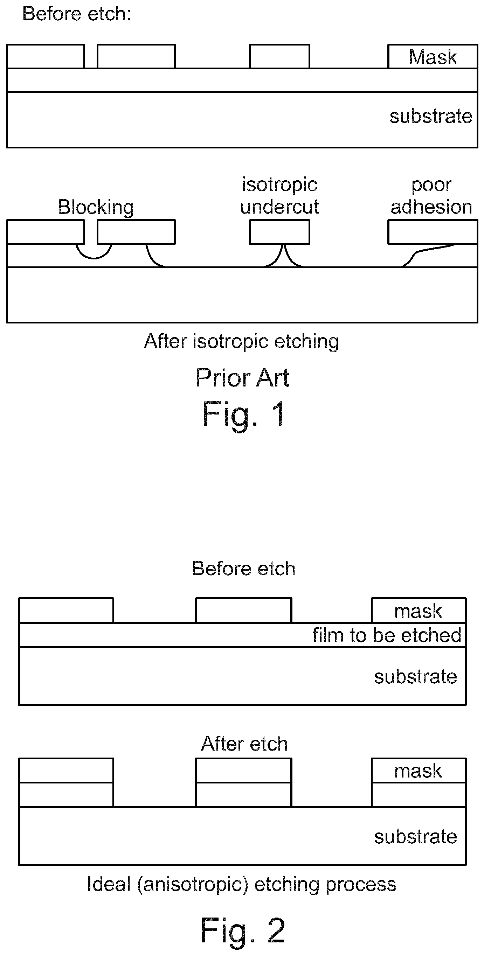

The PCB industry is in particular confronted with the task to adapt the size of the produced printed circuit boards to comply with the miniaturization requirements. Due to the new dimensions of the circuit paths, drill holes and their distance from each other, it is necessary to implement new etching techniques, in particular new copper etching processes. Although the copper etching process is one of the most important steps in the manufacture of printed circuit boards, processing of copper during fabrication is still a challenging task. In a conventional isotropic copper etching process as shown in Figure 1, when a copper film to be etched formed on a substrate and partly covered by a mask (as a negative template for patterning) is etched, undercuts may be formed beneath the mask due to isotropic etching, resulting in poor adhesion. In addition, isotropic etching may not be capable of forming very fine etching structures, but isotropic etching may be blocked by respective, fine masks structures.

The generation of fine structures with circuit paths of 30 microns and below may require an anisotropic etching process. In case of printed circuit boards, it is desired that the etching (in particular the copper removal) occurs more in the vertical direction rather than in the lateral direction. Hereby, regular structures may be obtained and short cuts may be avoided. An ideal anisotropic etching process is shown in Figure 2, wherein the etching exclusively occurs in the vertical direction, but not in the lateral direction of the PCB so that no undercuts are formed.

US 2006/0199394 A1 discloses an etching solution comprised of a cupric chloride solution and a high-concentration triazole type compound added to the cupric chloride solution and capable of forming an etching-inhibiting coating. In a process of forming a circuit pattern by etching with the etching solution, an etching-inhibiting coating is selected formed on parts of a copper foil laid under the edge of an etching resist to effectively inhibit horizontal side-etching of the copper foil from the edge of the etching resist. Also, nonuniform irregularities formed on the side wall of the circuit pattern by the etching improves the adhesion between the circuit pattern and an insulating resin layer covering the circuit pattern.

US 2011/0056910 A1 discloses an etching process carried out with an etchant that reacts with a metal to be etched to form an insoluble compound. After the etching using the above etchant, etching is carried out using an etchant that does not form an insoluble compound through a reaction with the metal to be etched, whereby the form of an etched portion comes close to a rectangular form, and the side surface of a conductor pattern becomes smooth.

US 5,858,257 discloses a method of preventing the occurrence of side etch in a wet etching method to form a circuit layer which meets the requirement of a high circuit density. First, etching is partially done using etchant having a relatively high etching rate with a spray pressure of a relatively small value, then etching is carried out using a second etchant having a relatively low etching rate with a high spray pressure.

EP 3 184 669 A1 discloses the use of an etching solution comprising an etching inhibitor followed by the use of an alkaline etching solution comprising a base.

It is an object of the invention to provide an etching process and an etching apparatus allowing an anisotropic etching of an electrically conductive layer structure and/or allowing the formation of a conductor track having a substantially regular shape, in particular with substantially vertical side walls, thereby increasing the overall quality of a component carrier, such as a printed circuit board.

In order to achieve the object defined above, a method of anisotropically etching an electrically conductive layer structure, and an apparatus for etching an electrically conductive layer structure according to the independent claims are provided.

According to an exemplary embodiment of the invention, a method of anisotropically etching an electrically conductive layer structure of a component carrier for forming a conductor track comprises the steps of (i) subjecting the electrically conductive layer structure to a first etching composition forming a recess having a bottom surface and side wall surfaces, wherein the first etching composition comprises an etchant and an etching inhibitor, (ii) subsequently (i.e. after step (i)) subjecting the (pre-etched) electrically conductive layer structure to a second etching composition being different from the first etching composition, and (iii) after step (ii), subjecting the electrically conductive layer structure to a third etching composition being different from both the first etching composition and the second etching composition and comprising an etchant and no etching inhibitor, wherein the second etching composition is configured for selectively removing the etching inhibitor and/or an inhibition layer formed after applying the first etching composition from the bottom surface of the recess rather than from the wall surfaces.

According to another exemplary embodiment of the invention, an apparatus for anisotropically etching an electrically conductive layer structure of a component carrier for forming a conductor track comprises a first etching stage configured for subjecting the electrically conductive layer structure to a first etching composition forming a recess having a bottom surface and side wall surfaces, wherein the first etching composition comprises an etchant and an etching inhibitor, a second etching stage configured for subsequently subjecting the (pre-etched) electrically conductive layer structure to a second etching composition being different from the first etching composition, and a third etching stage configured for subsequently subjecting the electrically conductive layer structure to a third etching composition being different from both the first etching composition and the second etching composition and comprising an etchant and no etching inhibitor, wherein the second etching composition is configured for selectively removing the etching inhibitor and/or an inhibition layer formed after applying the first etching composition from the bottom surface of the recess rather than from the side wall surfaces.

According to an exemplary embodiment resulting from the invention, a conductor track having a substantially rectangular cross-section is provided, wherein a ratio between the cross-sectional area of an upper third and the cross-sectional area of a central third is in a range between 0.8 and 1.2 and a ratio between the cross-sectional area of the central third and the cross-sectional area of a lower third is in a range between 0.8 and 1.2. In an embodiment, the conductor track may be formed by an etching process as described herein and/or by means of the etching apparatus as described herein.

According to an exemplary embodiment resulting from the invention, an arrangement of a first conductor track and a laterally directly neighbored second conductor track both having a substantially rectangular cross-section is provided, wherein a ratio between a distance between upper plateaus of the conductor tracks and a distance between lower ends of the conductor tracks is in a range between 0.7 and 1.3. In an embodiment, the first conductor track and/or the second conductor track (in particular both conductor tracks) of the arrangement may be formed by an etching process as described herein and/or by means of the etching apparatus as described herein.

According to an exemplary embodiment resulting from the invention, a component carrier is provided which comprises a stack of at least one electrically insulating layer structure and at least one electrically conductive layer structure, wherein at least a part of at least one electrically conductive layer structure comprises a conductor track as described herein and/or an arrangement as described herein.

In the context of the present application, the term "etching composition" may particularly denote a fluid, such as a solution or a liquid, which is capable of at least partly etching (dissolving) an electrically conductive material, such as a metal, in particular - but not limited to - copper, aluminum, nickel or silver. To this end, the etching composition may in particular comprise an etchant (etching agent) representing a reactive component of the composition substantially responsible for the at least partly etching (dissolving) an electrically conductive material.

In the context of the present application, the feature of an etching composition "being different from" another etching composition may particularly mean that the two (different) etching compositions include different components, rather than merely different concentrations of the same components. For example, an etching composition comprising components A and B is different within the meaning of the present application from an etching composition comprising components A and C. Moreover, an etching composition comprising components A and B is different within the meaning of the present application from an etching composition comprising component A and being (substantially) free of component B. In contrast, an etching composition comprising components A and B is typically not different within the meaning of the present application from an etching composition also comprising components A and B, but in different concentrations.

According to an exemplary embodiment of the invention, an etching process is provided wherein a sequence of different etching compositions are applied thereby promoting an anisotropic etching of an electrically conductive layer structure so that conductor tracks may be formed having a substantially regular shape, in particular with substantially vertical side walls. Without wishing to be bound to any theory, it is believed that due to the application of a sequence of different etching compositions the etching process may be controlled such that an etching in a vertical direction of a recess (cavity) formed in the electrically conductive layer structure during etching (i.e. an etched structure) is promoted compared with an etching in a lateral direction of the etched structure. For example, by the application of a sequence of different etching compositions a selective etching inhibition at specific locations of the etched structure may be achieved resulting in an anisotropic etching.

In the following, further exemplary embodiments of the method of etching an electrically conductive layer structure, the apparatus for etching an electrically conductive layer structure, the resulting conductor track, the resulting arrangement of at least two conductor tracks, and the resulting component carrier will be explained. However, the present invention is not limited to the following specific descriptions of exemplary embodiments, but they are rather for illustrative purposes only.

It should be noted that features described in connection with one exemplary embodiment or exemplary aspect may be combined with any other exemplary embodiment or exemplary aspect, in particular features described with any exemplary embodiment of an etching process may be combined with any other exemplary embodiment of an etching process and any exemplary embodiment of an etching apparatus, a conductor track, an arrangement of at least two conductor tracks, and a component carrier and vice versa, unless specifically stated otherwise.

Where an indefinite or definite article is used when referring to a singular term, such as "a", "an" or "the", a plural of that term is also included and vice versa, unless specifically stated otherwise, whereas the word "one" or the number "1", as used herein, typically means "just one" or "exactly one".

It should be noted that the term "comprising" does not exclude other elements or steps and, as used herein, includes not only the meaning of "comprising", "including" or "containing", but also encompasses "consisting essentially of" and "consisting of".

Unless specifically stated otherwise, the expressions "at least partially", "at least partly", "at least part of" or "at least a part of", as used herein, may mean at least 1 % thereof, in particular at least 5 % thereof, in particular at least 10 % thereof, in particular at least 15 % thereof, in particular at least 20 % thereof, in particular at least 25 % thereof, in particular at least 30 % thereof, in particular at least 35 % thereof, in particular at least 40 % thereof, in particular at least 45 % thereof, in particular at least 50 % thereof, in particular at least 55 % thereof, in particular at least 60 % thereof, in particular at least 65 % thereof, in particular at least 70 % thereof, in particular at least 75 % thereof, in particular at least 80 % thereof, in particular at least 85 % thereof, in particular at least 90 % thereof, in particular at least 95 % thereof, in particular at least 98 % thereof, and may also include 100 % thereof.

According to the invention, the method of etching an electrically conductive layer structure of a component carrier for forming a conductor track comprises consecutively subjecting the electrically conductive layer structure (in particular at the same position or location thereof, which position or location may thus also be referred to as "pre-etched" or "previously etched" in step (ii)) to at least three different etching compositions.

In an embodiment, the (first, second, etc.) etching compositions are liquid, such as a solution. The etching compositions may be prepared by dissolving the various ingredients, as exemplified in further detail in the following, in an appropriate solvent, such as water and/or an organic solvent. Thus, the etching compositions may comprise a solvent, such as water and/or an organic solvent. Moreover, the method of etching may thus be a wet etching process.

According to the invention, the first etching composition comprises an etchant and an etching inhibitor. Without wishing to be bound to any theory, it is believed that hereby it might be possible to form a (first, initial) recess or cavity in the electrically conductive layer structure, in particular by means of the etchant, whereas the etching inhibitor may adhere to surfaces of a thus formed recess thereby forming a protective layer on these surfaces. Subjecting the electrically conductive layer structure to such a first etching composition may result in an isotropic etching.

In an embodiment, the etchant comprises at least one of cupric chloride (CuCl₂) and ferric chloride (FeCl₃). Alternatively, an alkaline etchant may be employed, too. It might be advantageous that the etchant comprises cupric chloride (CuCl₂), in particular when the etching process is an etching process for etching an electrically conductive layer structure for forming a conductor track of a component carrier.

In an embodiment, the etching inhibitor may be selected depending on the specific etchant employed. For example, in case the etchant comprises cupric chloride, a complexing (or chelating) agent for Cu²⁺ ions may be appropriate, whereas in case the etchant comprise ferric chloride, a complexing (or chelating) agent for Fe³⁺ ions may be appropriate.

In an embodiment, the etching inhibitor is selected from the group consisting of azoles, amines, amino acids, triphenylmethanes, thiols, organic phosphates and various other organic compounds, such as xanthates, phthalazines, phthalimides, polyphenols, uracils, purines and anilines. In an embodiment, the etching inhibitor may comprise an azole.

In an embodiment, examples of azole etching inhibitors include thiazoles, thiadiazoles, imidazoles, triazoles, and tetrazoles. Examples of amine etching inhibitors include secondary amines and diamines. Examples of amino acid etching inhibitors include cystein and tryptophan. Examples of triphenylmethane etching inhibitors include fuchsine or rosaniline hydrochloride. Examples of amine etching inhibitors include dithiols. Examples of organic phosphate etching inhibitors include trimethyl phosphate and triphenylphosphate.

In an embodiment, the etching inhibitor comprises an ionizable compound, in particular a compound whose ionization state is pH-dependent (i.e. which may be protonated and/or deprotonated). Thus, the etching inhibitor may comprise an acidic and/or a basic functional group.

In an embodiment, the etching inhibitor is contained in the first etching composition in a concentration of from 0.001 g/l to 10 g/l, in particular of from 0.01 g/l to 5 g/l.

In an embodiment, the second etching composition is configured for (at least) partly removing (releasing) the etching inhibitor, such as from a recess formed in a first step, in particular from a part of the surfaces of a thus formed recess. In particular, the second etching composition may be configured for removing the etching inhibitor selectively from a bottom surface of a recess formed in a first step, rather than from side wall surfaces (lateral surfaces) of the recess.

In an embodiment, the second etching composition is configured for deprotonating (at least part of) the etching inhibitor and/or dissolving (or washing out) an inhibition layer formed on a surface of a recess after the step of applying the first etching composition. By deprotonating the etching inhibitor, it may be possible to reduce an adherence of the etching inhibitor to a surface of a recess formed in a first step so that the etching inhibitor may release or detach from the surface. In particular, the second etching composition may be configured for deprotonating the etching inhibitor and/or dissolving (or washing out) an inhibition layer selectively at a bottom surface of a recess formed in a first step, rather than at side wall surfaces (lateral surfaces) of the recess.

According to the invention, the second etching composition is configured for (at least partly) detaching the etching inhibitor from a surface. In particular, the second etching composition is configured for detaching the etching inhibitor selectively from a bottom surface of a recess formed in a first step, rather than from side wall surfaces (lateral surfaces) of the recess.

Without wishing to be bound to any theory, it is believed that a selective removing, deprotonating and/or detaching of the etching inhibitor from/at a bottom surface of a recess formed in a first step rather than from/at side wall surfaces (lateral surfaces) of the recess may be a result of a turbulent flow of the second etching composition which flow is more turbulent in the middle or center of a recess than at the side walls so that the second etching composition comes into contact more with an etching inhibitor adhered to a bottom surface of the recess than with an with an etching inhibitor adhered to the side walls of the recess.

In an embodiment, the second etching composition may have a pH value of 7 or higher, in particular a pH value of 7.5 or higher, such as a pH value of 8 or higher. However, a second etching composition having a pH value of lower than 7 may also be suitable.

In an embodiment, a pH value of the second etching composition may be higher than a pH value of the first etching composition, depending on the composition of the etchant applied in the first step (i.e. the first etching composition). In particular, the pH value of the second etching composition may be higher than the pH value of the first etching composition by for example at least 3 pH units, in particular by at least 4 pH units, such as by at least 5 pH units.

In an embodiment, the second etching composition comprises an alkaline compound (i.e. a compound capable of receiving one or more hydrogen atoms), such as a base, and/or an organic solvent, depending on the composition of the etchant applied in the first step (i.e. the first etching composition).

In an embodiment, the second etching composition further comprises a rheological additive. In the context of the present application, the term "rheological additive" may particularly denote a compound capable of modifying the rheological behavior of the etching composition. The rheological additive may comprise an organic compound and/or an inorganic compound.

In an embodiment, the rheological additive is selected from the group consisting of silica, hydroxyethyl cellulose, phyllosilicates and urea. The silica may in particular be a hydrophilic and/or pyrogenic and/or amorphous silica, such as HDK N20 (commercially available from Wacker Chemie AG, München, Germany). The hydroxyethyl cellulose may in particular be a water-soluble hydroxyethyl cellulose, such as Natrosol 250 HHBR or Natrosol 250 HHX (commercially available from Ashland Inc., Covington, USA). The phyllosilicate may in particular be a hydrated phyllosilicate, such as Optigel WX (commercially available from Byk-Chemie GmbH, Wesel, Germany). The urea may in particular be a modified urea, such as Byk-7420 ES (commercially available from Byk-Chemie GmbH, Wesel, Germany).

Without wishing to be bound to any theory, the following is assumed: Based on the theory of spray-etching, as mentioned earlier, the flow of an etching composition is more turbulent in the middle or center of a recess so that the liquid is more agitated there than at the side walls of the recess. In this situation, the addition of a rheological additive to the etching composition may cause an increase in density and/or in viscosity of the etching composition near to the side walls in comparison to the middle of the recess. As a general rule, the lower the density and/or the viscosity of the etching composition, the easier a component exchange between the etching liquid and the surface (where for instance an etching inhibitor is adhered). As a consequence, the addition of a rheological additive may result in an even further pronounced selectivity in removing, deprotonating and/or detaching the etching inhibitor from/at a bottom surface of a recess formed in a first step rather than from/at side wall surfaces (lateral surfaces) of the recess, thereby further increasing the anisotropy of the etching process and the resulting etched structures.

In an embodiment, the rheological additive is contained in the second etching composition in a concentration of from 0.001 g/l to 10 g/l, in particular of from 0.01 g/l to 5 g/l.

According to the invention, the method of etching an electrically conductive layer structure of a component carrier for forming a conductor track comprises a step (iii), after step (ii), of subjecting the (pre-etched or pre-treated) electrically conductive layer structure to a third etching composition being different from both the first etching composition and the second etching composition.

According to the invention, the third etching composition comprises an etchant and is substantially free of an etching inhibitor. The etchant may be the same etchant as the etchant of the first etching composition or may be a different etchant. It may be advantageous that the etchant of the third etching composition is the same etchant as used in the first etching composition. However, in contrast to the first etching composition, the third etching composition may be substantially free of an etching inhibitor. In the context of the present application, the term "substantially free of an etching inhibitor" may particularly denote that no etching inhibitor at all is contained or if any etching inhibitor is contained (for example due to technical (unavoidable) reasons), it is contained in an amount that does not exhibit any significant etchant-inhibiting activity.

Without wishing to be bound to any theory, it is believed that if in the second process step an etching inhibitor from the first step has been selectively removed, deprotonated and/or detached from/at a bottom surface of a recess formed in a first step rather than from/at side wall surfaces (lateral surfaces) of the recess, a third etching composition comprising an etchant, but substantially no etching inhibitor, may selectively exert its etching activity at that surface of the recess which is not protected by an etching inhibitor, i.e. at the bottom surface of the recess, whereas at surfaces of the recess protected by an etching inhibitor (such as the side wall surfaces), the etchant contained in the third etching composition may hardly exert its etching activity. As a result, the etching may proceed in a vertical direction of the recess, rather than in a lateral direction.

In an embodiment, the third etching composition further comprises a surface-active agent, such as a surfactant. Hereby, an exchange of components on surfaces may be improved. The surfactant may be at least one selected from the group consisting of an anionic surfactant, a cationic surfactant, a nonionic surfactant and a zwitterionic surfactant. In particular, the surfactant may be at least one selected from the group consisting of an anionic surfactant, a cationic surfactant and a nonionic surfactant. More specifically, the surfactant may be at least one of an anionic surfactant and a cationic surfactant and even more specifically the surfactant may comprise an anionic surfactant.

In an embodiment, the electrically conductive layer structure is subjected to a subtractive etching procedure for forming the conductor track, in particular a subtractive wet etching procedure for forming the conductor track. Thus, the etching process may be a subtractive etching process.

In an embodiment, the subjecting the electrically conductive layer structure to the (first, second, etc.) etching composition comprises a spraying the respective etching composition on (a surface of) the electrically conductive layer structure.

In an embodiment, the etching process may be carried out by means of an etching apparatus as described herein.

In an embodiment, the sequence of process steps (i), (ii) and (iii) may be repeated several times, for instance at least once, such as at least twice, in particular at least three times. Hereby, still deeper etching structures may be formed. In the first and any subsequent repetition of the sequence of process steps, the process step (i) may be modified in that the first etching composition may not comprise an etchant anymore because an initial recess has already been formed after the first sequence of process steps.

In an embodiment, subsequent to subjecting the electrically conductive layer structure to the etching compositions, the (etched) electrically conductive layer structure may be subjected to a rinsing liquid.

In an embodiment, the rinsing liquid comprises a compound configured for adjusting a porosity of an etched surface and/or for protecting a (copper) surface from interaction with air (in the following referred to as "rinsing liquid additive").

In an embodiment, the rinsing liquid additive may be selected from the group consisting of ethoxylated amides, (ethoxylated) amines, fatty acids, phosphonic acid esters, alkanolamine phosphonates and dispersing agents.

According to the invention, the etching apparatus comprises a first etching stage configured for subjecting the electrically conductive layer structure to a first etching composition and a second etching stage configured for subsequently subjecting the (pre-etched) electrically conductive layer structure to a second etching composition being different from the first etching composition.

According to the invention, the etching apparatus is configured (or is suitable) for carrying out the etching process as described herein.

According to the invention, the etching apparatus further comprises a third etching stage configured for subsequently subjecting the (pre-etched or pre-treated) electrically conductive layer structure to a third etching composition being different from both the first etching composition and the second etching composition.

In an embodiment, the etching apparatus comprises spraying nozzles by means of which the respective etching compositions may be applied, in particular sprayed, (on)to the electrically conductive layer structure of the component carrier.

In an embodiment, the etching apparatus comprises a conveyor by means of which the component carrier may be transported from one etching stage to another etching stage, in particular from the first etching stage to the second etching stage and, if present, further to the third etching stage.

In an embodiment resulting from the invention, the conductor track having a substantially rectangular cross-section is characterized by a ratio between the cross-sectional area of an upper third and the cross-sectional area of a central third being in a range between 0.8 and 1.2, in particular between 0.85 and 1.15, in particular between 0.9 and 1.1, in particular between 0.93 and 1.07, in particular between 0.94 and 1.06, in particular between 0.95 and 1.05, and a ratio between the cross-sectional area of the central third and the cross-sectional area of a lower third being in a range between 0.8 and 1.2, in particular between 0.85 and 1.15, in particular between 0.9 and 1.1, in particular between 0.93 and 1.07, in particular between 0.94 and 1.06, in particular between 0.95 and 1.05.

In an embodiment resulting from the invention, the conductor track may be further characterized by a ratio between the cross-sectional area of an upper third and the cross-sectional area of a lower third being in a range between 0.7 and 1.3, in particular between 0.8 and 1.2, in particular between 0.9 and 1.1 in particular between 0.92 and 1.08, in particular between 0.94 and 1.06.

In an embodiment resulting from the invention, the conductor track may be formed by an etching process as described herein and/or by means of the etching apparatus as described herein.

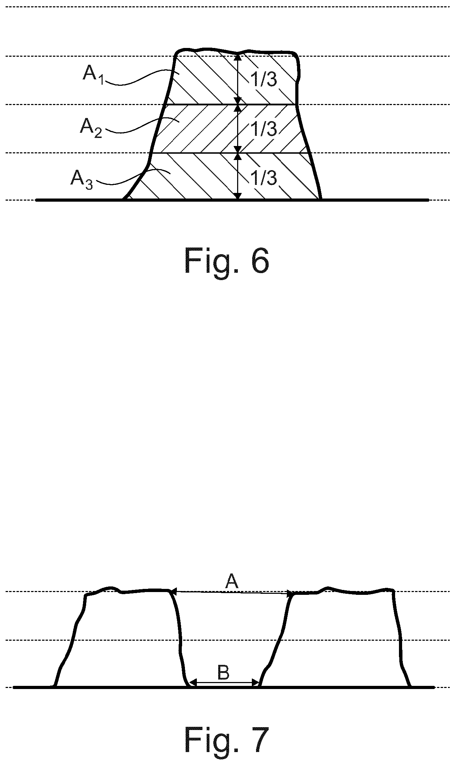

In the context of the present application, the term "cross-sectional area" of an upper, central and lower third, respectively, may particularly denote the cross-sectional area of a conductor track when cut in a vertical direction and horizontally subdivided in three thirds of equal heights, as it will be further apparent from the illustration of Figure 6 and the corresponding explanations below.

In the context of the present application, the term "substantially rectangular cross-section" may particularly denote that at least one, in particular at least two, of the above described cross-sectional area ratios lies within the respective above described range(s). Alternatively or additionally, the term "substantially rectangular cross-section" may denote that the distance ratio as described in the following lies within a range as described in the following.

In an embodiment resulting from the invention, the arrangement of a first conductor track and a laterally directly neighbored second conductor track both having a substantially rectangular cross-section is characterized by a ratio between a distance between upper plateaus of the conductor tracks and a distance between lower ends of the conductor tracks being in a range between 0.7 and 1.3, in particular between 0.8 and 1.2, in particular between 0.85 and 1.15, in particular between 0.9 and 1.1, in particular between 0.92 and 1.08, in particular between 0.95 and 1.05.

In an embodiment resulting from the invention, the distance between upper plateaus of the conductor tracks and/or the distance between lower ends of the conductor tracks may be lower than 50 µm, such as 30 µm or less.

In an embodiment resulting from the invention, the first conductor track and/or the second conductor track (in particular both conductor tracks) of the arrangement may be formed by an etching process as described herein and/or by means of the etching apparatus as described herein.

In an embodiment, the component carrier comprises a stack of at least one electrically insulating layer structure and at least one electrically conductive layer structure, wherein at least a part of at least one electrically conductive layer structure comprises a conductor track as described herein and/or an arrangement as described herein.

In an embodiment, the part of the at least one electrically conductive layer structure comprising the conductor track and/or the arrangement may be at least partly exposed.

In an embodiment, the part of the at least one electrically conductive layer structure comprising the conductor track and/or the arrangement may be at least partly sandwiched between two electrically insulating layers and/or at least partly embedded within one electrically insulating layer structure.

In the context of the present application, the term "component carrier" may particularly denote any support structure which is capable of accommodating one or more components thereon and/or therein for providing mechanical support and/or electrical connectivity. In other words, a component carrier may be configured as a mechanical and/or electronic carrier for components. In particular, a component carrier may be one of a printed circuit board, an organic interposer, and an IC (integrated circuit) substrate. A component carrier may also be a hybrid board combining different ones of the above mentioned types of component carriers.

In the context of the present application, the term "electronic component" may particularly denote any bulky rather than layer-type active (such as a semiconductor chip) or passive (for instance a copper block) component embedded within an interior of the component carrier.

In an embodiment, the component may be selected from a group consisting of an electrically non-conductive inlay, an electrically conductive inlay (such as a metal inlay, preferably comprising copper or aluminum), a heat transfer unit (for example a heat pipe), a light guiding element (for example an optical waveguide or a light conductor connection), an electronic component, or combinations thereof. For example, the component can be an active electronic component, a passive electronic component, an electronic chip, a storage device (for instance a DRAM or another data memory), a filter, an integrated circuit, a signal processing component, a power management component, an optoelectronic interface element, a voltage converter (for example a DC/DC converter or an AC/DC converter), a cryptographic component, a transmitter and/or receiver, an electromechanical transducer, a sensor, an actuator, a microelectromechanical system (MEMS), a microprocessor, a capacitor, a resistor, an inductance, a battery, a switch, a camera, an antenna, a logic chip, and an energy harvesting unit. However, other components may be embedded in the component carrier. For example, a magnetic element can be used as a component. Such a magnetic element may be a permanent magnetic element (such as a ferromagnetic element, an antiferromagnetic element or a ferrimagnetic element, for instance a ferrite core) or may be a paramagnetic element. However, the component may also be a further component carrier, for example in a board-in-board configuration. The component may be surface mounted on the component carrier and/or may be embedded in an interior thereof. Moreover, also other components, in particular those which generate and emit electromagnetic radiation and/or are sensitive with regard to electromagnetic radiation propagating from an environment, may be used as component.

In an embodiment, the component carrier comprises a stack of at least one electrically insulating layer structure and at least one electrically conductive layer structure. For example, the component carrier may be a laminate of the mentioned electrically insulating layer structure(s) and electrically conductive layer structure(s), in particular formed by applying mechanical pressure, if desired supported by thermal energy. The mentioned stack may provide a plate-shaped component carrier capable of providing a large mounting surface for further components and being nevertheless very thin and compact. The term "layer structure" may particularly denote a continuous layer, a patterned layer or a plurality of non-consecutive islands within a common plane.

In an embodiment, the component carrier is shaped as a plate. This contributes to the compact design, wherein the component carrier nevertheless provides a large basis for mounting components thereon. Furthermore, in particular a naked die as example for an embedded electronic component, can be conveniently embedded, thanks to its small thickness, into a thin plate such as a printed circuit board.

In an embodiment, the component carrier is configured as one of the group consisting of a printed circuit board, and a substrate (in particular an IC substrate).

In the context of the present application, the term "printed circuit board" (PCB) may particularly denote a component carrier (which may be plate-shaped (i.e. planar), three-dimensionally curved (for instance when manufactured using 3D printing) or which may have any other shape) which is formed by laminating several electrically conductive layer structures with several electrically insulating layer structures, for instance by applying pressure, if desired accompanied by the supply of thermal energy. As preferred materials for PCB technology, the electrically conductive layer structures are made of copper, whereas the electrically insulating layer structures may comprise resin and/or glass fibers, so-called prepreg or FR4 material. The various electrically conductive layer structures may be connected to one another in a desired way by forming through-holes through the laminate, for instance by laser drilling or mechanical drilling, and by filling them with electrically conductive material (in particular copper), thereby forming vias as through-hole connections. Apart from one or more components which may be embedded in a printed circuit board, a printed circuit board is usually configured for accommodating one or more components on one or both opposing surfaces of the plate-shaped printed circuit board. They may be connected to the respective main surface by soldering. A dielectric part of a PCB may be composed of resin with reinforcing fibers (such as glass fibers).

In the context of the present application, the term "substrate" may particularly denote a small component carrier having substantially the same size as a component (in particular an electronic component) to be mounted thereon. More specifically, a substrate can be understood as a carrier for electrical connections or electrical networks as well as component carrier comparable to a printed circuit board (PCB), however with a considerably higher density of laterally and/or vertically arranged connections. Lateral connections are for example conductive paths, whereas vertical connections may be for example drill holes. These lateral and/or vertical connections are arranged within the substrate and can be used to provide electrical and/or mechanical connections of housed components or unhoused components (such as bare dies), particularly of IC chips, with a printed circuit board or intermediate printed circuit board. Thus, the term "substrate" also includes "IC substrates". A dielectric part of a substrate may be composed of resin with reinforcing spheres (such as glass spheres).

In an embodiment, the component carrier is a laminate-type component carrier. In such an embodiment, the component carrier is a compound of multiple layer structures which are stacked and connected together by applying a pressing force, if desired accompanied by heat.

In an embodiment, the at least one electrically insulating layer structure comprises at least one of the group consisting of resin (such as reinforced or non-reinforced resins, for instance epoxy resin or Bismaleimide-Triazine resin, more specifically FR-4 or FR-5), cyanate ester, polyphenylene derivate, glass (in particular glass fibers, multi-layer glass, glass-like materials), prepreg material, polyimide, polyamide, liquid crystal polymer (LCP), epoxy-based Build-Up Film, polytetrafluoroethylene (Teflon), a ceramic, and a metal oxide. Reinforcing materials such as webs, fibers or spheres, for example made of glass (multilayer glass) may be used as well. Although prepreg or FR4 are usually preferred, other materials may be used as well. For high frequency applications, high-frequency materials such as polytetrafluoroethylene, liquid crystal polymer and/or cyanate ester resins may be implemented in the component carrier as electrically insulating layer structure.

In an embodiment, the at least one electrically conductive layer structure comprises at least one of the group consisting of copper, aluminum, nickel, silver, gold, palladium, and tungsten. Although copper is usually preferred, other materials or coated versions thereof are possible as well, in particular coated with supra-conductive material such as graphene.

In an embodiment, the at least one electrically conductive layer structure, in particular the at least one electrically conductive layer structure comprising the conductor track and/or the arrangement, comprises at least one of the group consisting of copper, aluminum, nickel and silver.

The aspects defined above and further aspects of the invention are apparent from the exemplary embodiments to be described hereinafter and are explained with reference to these exemplary embodiments.
Figure 1 illustrates a conventional isotropic copper etching process according to the prior art.
Figure 2 illustrates an ideal anisotropic copper etching process according to an exemplary embodiment of the invention.
Figure 3 illustrates a photolithographic structuring of an electrically conductive layer structure of a component carrier by means of a photoresist involving a subtractive etching process according to an exemplary embodiment of the invention.
Figure 4 illustrates an etching apparatus according to an exemplary embodiment of the invention.
Figures 5A to 5C represent enlarged views of the etching process shown in Figure 3 according to an exemplary embodiment of the invention.
Figure 6 illustrates a cross-sectional view of a conductor track according to an exemplary embodiment resulting from the invention.
Figure 7 illustrates a cross-sectional view of an arrangement of conductor tracks according to an exemplary embodiment resulting from the invention.

The illustrations in the drawings are schematical. In different drawings, similar or identical elements are provided with the same reference signs.

Before, referring to the drawings, exemplary embodiments will be described in further detail, some basic considerations will be summarized based on which exemplary embodiments of the invention have been developed.

According to an exemplary embodiment of the invention, an etching process is provided wherein a sequence of different etching compositions are applied thereby promoting an anisotropic etching of an electrically conductive layer structure so that conductor tracks may be formed having a substantially regular shape, in particular with substantially vertical side walls. Without wishing to be bound to any theory, it is believed that due to the application of a sequence of different etching compositions the etching process may be controlled such that an etching in a vertical direction of a recess formed in the electrically conductive layer structure during etching (i.e. an etched structure) is promoted compared with an etching in a lateral direction of the etched structure. For example, by the application of a sequence of different etching compositions a selective etching inhibition at specific locations of the etched structure may be achieved resulting in an anisotropic etching. As an illustrative example, by subjecting an electrically conductive layer structure to a first etching composition comprising an etchant and an etching inhibitor, it might be possible to form a (first, initial) recess in the electrically conductive layer structure, in particular by means of the etchant, whereas the etching inhibitor may adhere to surfaces of a thus formed recess thereby forming a protective layer on these surfaces. Subsequently, by subjecting the thus pre-etched electrically conductive layer structure to a second etching composition having for instance a higher pH value than the first etching composition, it might be possible to selectively remove the etching inhibitor from a bottom surface rather than from the side wall surfaces of the recess. Next, by subjecting the thus pre-treated electrically conductive layer structure to a third etching composition comprising an etchant but substantially no etching inhibitor, it might be possible to selectively etch at the bottom surface of the recess, rather than at the side wall surfaces of the recess. In other words, the etching may mainly proceed in a vertical direction rather than in a lateral direction. As a result, the overall quality of a component carrier, such as a printed circuit board, may be increased, in particular in terms of a decreased defect rate as well as an improved etching distribution (increased homogeneity) within the produced boards and a higher etching factor of etched structures. In addition, a line width lower than 50 µm, such as 30 µm or less, may be achieved.

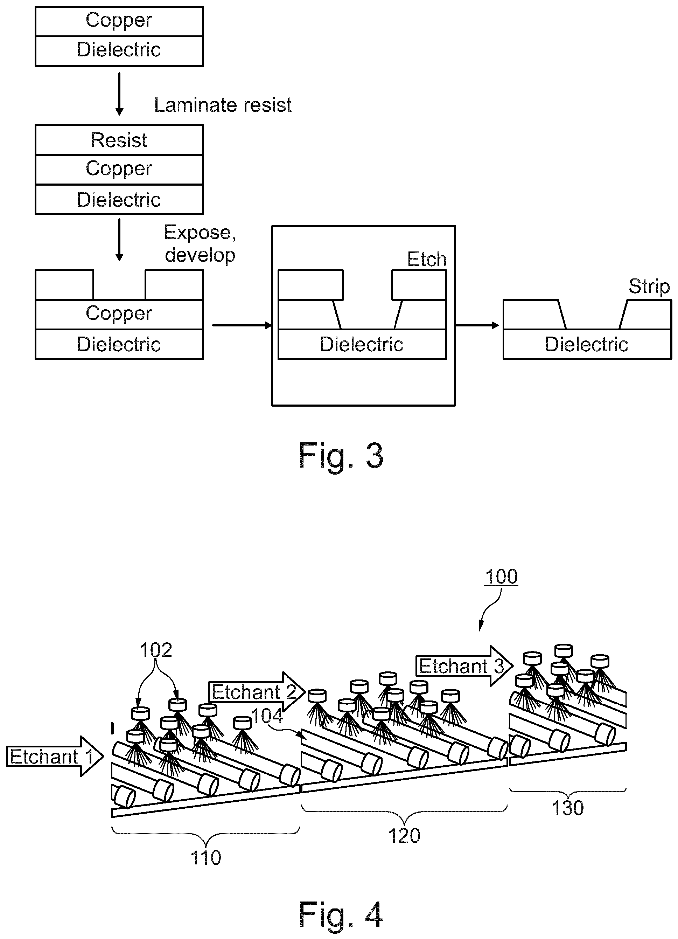

**Figure 3** illustrates a photolithographic structuring of an electrically conductive layer structure of a component carrier by means of a photoresist involving a subtractive etching process according to an exemplary embodiment of the invention. In a first step, a laminate or stack of an electrically insulating layer structure (such as made of a dielectric) and an electrically conductive layer structure (such as made of copper) to be etched is provided. Next, a photoresist layer is applied on the electrically conductive layer structure. Then, the photoresist is partly exposed (through a mask, not shown) to electromagnetic radiation (such as UV light) and developed, thereby removing that part of the photoresist that has been exposed to the electromagnetic radiation. In the next step, a subtractive etching process according to an exemplary embodiment of the method of etching of the invention is performed (highlighted by a frame). Hereby, the electrically conductive layer structure is anisotropically etched so that the side walls of a recess formed in the electrically conductive layer structure are substantially vertical, even though a slight undercut beneath the photoresist is shown in Figure 3. Finally, the remaining photoresist (such as that part of the photoresist that has not been exposed to the electromagnetic radiation before) is removed, for instance stripped off, and an arrangement of conductor tracks according to an exemplary embodiment of the invention on the dielectric is obtained.

**Figure 4** illustrates an etching apparatus 100 according to an exemplary embodiment of the invention. The etching apparatus 100 shown in Figure 4 comprises three etching stages: a first etching stage 110, a second etching stage 120 and a third etching stage 130. A component carrier comprising an electrically conductive layer structure to be etched (not shown in Figure 4) can be transported from the first etching stage 110 to the second etching stage 120 and further to the third etching stage 130 by means of a conveyor 104. Moreover, each etching stage 110, 120 and 130 comprises spraying nozzles 102 by means of which the respective etching compositions may be sprayed (on)to the electrically conductive layer structure of the component carrier.

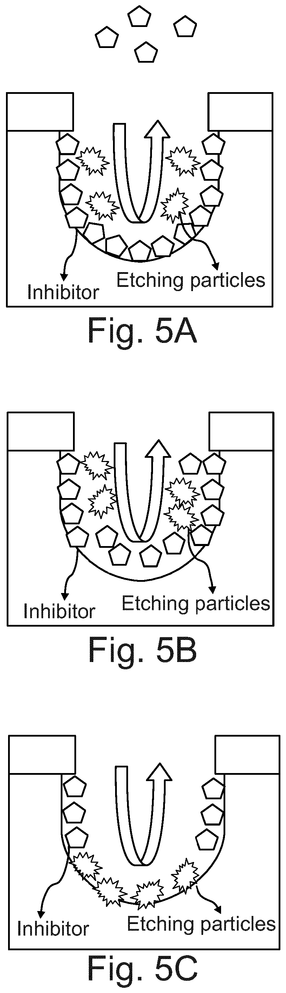

**Figure 5A** to **5C** represent enlarged views of the etching process highlighted by the frame in Figure 3 according to an exemplary embodiment of the invention.

Referring to **Figure 5A****,** a first etching composition is applied. The first etching composition comprises "etching particles" (i.e. an etchant) and an "inhibitor" (i.e. an etching inhibitor). As shown in Figure 5A, the inhibitor adheres to surfaces of a recess formed by the etching particles.

Referring to **Figure 5B****,** a second etching composition is applied. The application of the second etching composition results in a selective detachment of the inhibitor from a bottom surface rather than from the side wall surfaces of the recess. Any detached inhibitor as well as the etching particles may be removed from the recess, such as purged or flushed out of the recess, by the second etching composition.

Referring to **Figure 5C****,** a third etching composition is applied. The first etching composition comprises "etching particles" (i.e. an etchant), but no fresh inhibitor. As shown in Figure 5C, the etching particles exert their etching activity at that surface portion of the recess which is not protected by inhibitor, i.e. at the bottom surface of the recess, whereas at surfaces of the recess protected by the inhibitor, i.e. the side wall surfaces of the recess, the etching particles contained in the third etching composition cannot exert their etching activity. As a result, the etching proceeds in a vertical direction of the recess, rather than in a lateral direction.

Referring to **Figure 6****,** a cross-sectional view of a conductor track having a substantially rectangular cross-section according to an exemplary embodiment resulting from the invention the invention is shown. In particular, the cross-sectional view shown in Figure 6 is a cross-sectional view in vertical direction of the conductor track, i.e. a view of the conductor track when cut in a vertical direction. In addition, as depicted in Figure 6, the conductor track is horizontally subdivided in three thirds of equal heights. As a result, a cross-sectional area of an upper third (A1), a cross-sectional area of a central third (A2) and a cross-sectional area of a lower third (A3) are obtained. The conductor track according to an exemplary embodiment is characterized by a ratio between the cross-sectional area of the upper third (A1) and the cross-sectional area of a central third (A2) being in a range between 0.8 and 1.2 and a ratio between the cross-sectional area of the central third (A2) and the cross-sectional area of the lower third (A3) being in a range between 0.8 and 1.2. In an embodiment, the conductor track may be further characterized by a ratio between the cross-sectional area of the upper third (A1) and the cross-sectional area of the lower third (A3) being in a range between 0.7 and 1.3.

Referring to **Figure 7****,** a cross-sectional view of an arrangement of conductor tracks according to an exemplary embodiment resulting from the invention the invention is shown. In particular, the cross-sectional view shown in Figure 7 is a cross-sectional view in vertical direction of the arrangement of conductor tracks, i.e. a view when the conductor tracks were cut in a vertical direction. Figure 7 depicts a first conductor track (for instance the conductor track on the left) and a second conductor track (for instance the conductor track on the right). Figure 7 further depicts an arrowed line A representing a distance between upper plateaus of the conductor tracks and an arrowed line B representing a distance between lower ends of the conductor tracks. The arrangement of conductor tracks according to an exemplary embodiment is characterized by a ratio between the distance A between upper plateaus of the conductor tracks and the distance B between lower ends of the conductor tracks being in a range between 0.7 and 1.3. The distance A and/or the distance B may be for instance lower than 50 µm, such as 30 µm or less.

It should be noted that reference signs in the claims shall not be construed as limiting the scope of the claims.

Implementation of the invention is not limited to the preferred embodiments shown in the figures and described above. Instead, a multiplicity of variants are possible which fall within the scope of the invention as defined by the appended claims.

## Claims

1. A method of anisotropically etching an electrically conductive layer structure of a component carrier for forming a conductor track, wherein the method comprises the steps of:
(i) subjecting the electrically conductive layer structure to a first etching composition forming a recess having a bottom surface and side wall surfaces, wherein the first etching composition comprises an etchant and an etching inhibitor;
(ii) after step (i), subjecting the electrically conductive layer structure to a second etching composition being different from the first etching composition,
(iii) after step (ii), subjecting the electrically conductive layer structure to a third etching composition being different from both the first etching composition and the second etching composition and comprising an etchant and no etching inhibitor,
**characterized in that**
the second etching composition is configured for selectively removing the etching inhibitor and/or an inhibition layer formed after applying the first etching composition from the bottom surface of the recess rather than from the side wall surfaces.

2. The method according to claim 1, wherein the second etching composition has a pH value of 7 or higher.

3. The method according to any one of the preceding claims, wherein a pH value of the second etching composition is higher than a pH value of the first etching composition, in particular by at least 3 pH units.

4. The method according to any one of the preceding claims, wherein the second etching composition further comprises a rheological additive, in particular a rheological additive selected from the group consisting of silica, hydroxyethyl cellulose, phyllosilicates and urea.

5. The method according to any one of the preceding claims, wherein the electrically conductive layer structure is made subject to a subtractive etching procedure for forming the conductor track.

6. An apparatus (100) for anisotropically etching an electrically conductive layer structure of a component carrier for forming a conductor track, wherein the apparatus comprises:
a first etching stage (110) configured for subjecting the electrically conductive layer structure to a first etching composition forming a recess having a bottom surface and side wall surfaces, wherein the first etching composition comprises an etchant and an etching inhibitor;
a second etching stage (120) configured for subsequently subjecting the electrically conductive layer structure to a second etching composition being different from the first etching composition;
a third etching stage (130) configured for subsequently subjecting the electrically conductive layer structure to a third etching composition being different from both the first etching composition and the second etching composition and comprising an etchant and no etching inhibitor,
**characterized in that**
the second etching composition is configured for selectively removing the etching inhibitor and/or an inhibition layer formed after applying the first etching composition from the bottom surface of the recess rather than from the side wall surfaces.

## Patentansprüche

1. Verfahren des anisotropen Ätzens einer elektrisch leitfähigen Schichtstruktur eines Bauteilträgers zur Bildung einer Leiterbahn, wobei das Verfahren die folgenden Schritte umfasst:
(i) Aussetzen der elektrisch leitfähigen Schichtstruktur einer ersten Ätzzusammensetzung, die eine Vertiefung mit einer Bodenfläche und Seitenwandflächen bildet, wobei die erste Ätzzusammensetzung ein Ätzmittel und einen Ätzinhibitor umfasst;
(ii) nach Schritt (i), Aussetzen der elektrisch leitfähigen Schichtstruktur einer zweiten Ätzzusammensetzung, die sich von der ersten Ätzzusammensetzung unterscheidet,
(iii) nach Schritt (ii), Aussetzen der elektrisch leitfähigen Schichtstruktur einer dritten Ätzzusammensetzung, die sich sowohl von der ersten Ätzzusammensetzung als auch von der zweiten Ätzzusammensetzung unterscheidet und ein Ätzmittel und keinen Ätzinhibitor umfasst,
**dadurch gekennzeichnet, dass**
die zweite Ätzzusammensetzung ausgelegt ist, den Ätzinhibitor und/oder eine nach dem Auftragen der ersten Ätzzusammensetzung gebildete Inhibitionsschicht selektiv von der Bodenfläche der Vertiefung und nicht von den Seitenwandflächen zu entfernen.

2. Verfahren nach Anspruch 1, wobei die zweite Ätzzusammensetzung einen pH-Wert von 7 oder höher aufweist.

3. Verfahren nach einem der vorhergehenden Ansprüche, wobei ein pH-Wert der zweiten Ätzzusammensetzung höher ist als ein pH-Wert der ersten Ätzzusammensetzung, insbesondere um mindestens 3 pH-Einheiten.

4. Verfahren nach einem der vorhergehenden Ansprüche, wobei die zweite Ätzzusammensetzung ferner ein rheologisches Additiv, insbesondere ein rheologisches Additiv, ausgewählt aus der Gruppe bestehend aus Siliciumdioxid, Hydroxyethylcellulose, Schichtsilikaten und Harnstoff, umfasst.

5. Verfahren nach einem der vorhergehenden Ansprüche, wobei die elektrisch leitfähige Schichtstruktur zur Bildung der Leiterbahn einem subtraktiven Ätzverfahren unterzogen wird.

6. Vorrichtung (100) für ein anisotropes Ätzen einer elektrisch leitfähigen Schichtstruktur eines Bauteilträgers zur Bildung einer Leiterbahn, wobei die Vorrichtung umfasst:
eine erste Ätzstufe (110), die ausgelegt ist, die elektrisch leitfähige Schichtstruktur einer ersten Ätzzusammensetzung auszusetzen, die eine Vertiefung mit einer Bodenfläche und Seitenwandflächen bildet, wobei die erste Ätzzusammensetzung ein Ätzmittel und einen Ätzinhibitor umfasst;
eine zweite Ätzstufe (120), die ausgelegt ist, die elektrisch leitfähige Schichtstruktur anschließend einer zweiten Ätzzusammensetzung auszusetzen, die sich von der ersten Ätzzusammensetzung unterscheidet;
eine dritte Ätzstufe (130), die ausgelegt ist, die elektrisch leitfähige Schichtstruktur anschließend einer dritten Ätzzusammensetzung auszusetzen, die sich sowohl von der ersten Ätzzusammensetzung als auch von der zweiten Ätzzusammensetzung unterscheidet und ein Ätzmittel und keinen Ätzinhibitor umfasst,
**dadurch gekennzeichnet, dass**
die zweite Ätzzusammensetzung ausgelegt ist, den Ätzinhibitor und/oder eine nach dem Auftragen der ersten Ätzzusammensetzung gebildete Inhibitionsschicht selektiv von der Bodenfläche der Vertiefung und nicht von den Seitenwandflächen zu entfernen.

## Revendications

1. Procédé de gravure anisotrope d'une structure de couche électroconductrice d'un support de composant pour former une piste conductrice, dans lequel le procédé comprend les étapes suivantes :
(i) la soumission de la structure de couche électroconductrice à une première composition de gravure formant un évidement ayant une surface inférieure et des surfaces de paroi latérale, dans lequel la première composition de gravure comprend un agent de gravure et un inhibiteur de gravure ;
(ii) après l'étape (i), la soumission de la structure de couche électroconductrice à une deuxième composition de gravure qui est différente de la première composition de gravure,
(iii) après l'étape (ii), la soumission de la structure de couche électroconductrice à une troisième composition de gravure qui est différente à la fois de la première composition de gravure et de la deuxième composition de gravure et comprenant un agent de gravure et aucun inhibiteur de gravure,
**caractérisé en ce que**
la deuxième composition de gravure est configurée pour éliminer sélectivement l'inhibiteur de gravure et/ou une couche d'inhibition formés après l'application de la première composition de gravure de la surface inférieure de l'évidement plutôt que des surfaces de parois latérales.

2. Procédé selon la revendication 1, dans lequel la deuxième composition de gravure a une valeur de pH de 7 ou plus.

3. Procédé selon l'une quelconque des revendications précédentes, dans lequel une valeur de pH de la deuxième composition de gravure est supérieure à une valeur de pH de la première composition de gravure, en particulier d'au moins 3 unités de pH.

4. Procédé selon l'une quelconque des revendications précédentes, dans lequel la deuxième composition de gravure comprend en outre un additif rhéologique, en particulier un additif rhéologique choisi dans le groupe constitué par la silice, l'hydroxyéthylcellulose, les phyllosilicates et l'urée.

5. Procédé selon l'une quelconque des revendications précédentes, dans lequel la structure de couche électroconductrice est soumise à une procédure de gravure soustractive pour former la piste conductrice.

6. Appareil (100) pour graver de manière anisotrope une structure de couche électroconductrice d'un support de composant pour former une piste conductrice, dans lequel l'appareil comprend :
une première étape de gravure (110) configurée pour soumettre la structure de couche électroconductrice à une première composition de gravure formant un évidement ayant une surface inférieure et des surfaces de paroi latérale, dans lequel la première composition de gravure comprend un agent de gravure et un inhibiteur de gravure ;
une deuxième étape de gravure (120) configurée pour soumettre ensuite la structure de couche électroconductrice à une deuxième composition de gravure qui est différente de la première composition de gravure ;
une troisième étape de gravure (130) configurée pour soumettre ensuite la structure de couche électroconductrice à une troisième composition de gravure qui est différente à la fois de la première composition de gravure et de la deuxième composition de gravure et comprenant un agent de gravure et aucun inhibiteur de gravure,
**caractérisé en ce que**
la deuxième composition de gravure est configurée pour éliminer sélectivement l'inhibiteur de gravure et/ou une couche d'inhibition formés après l'application de la première composition de gravure de la surface inférieure de l'évidement plutôt que des surfaces de parois latérales.
